# EUROPEAN PATENT APPLICATION

(11) **EP 4 572 107 A1**
(43) Date of publication of application: **18.06.2025**
(21) Application number: 22960352.7
(22) Date of filing: 30.09.2022
(51) Int. Cl.: H02K 11/26

(54) **VOLTAGE DETECTION DEVICE**

(71) Applicant: Contemporary Amperex Technology Co., Limited, Ningde, Fujian 352100 (CN); Contemporary Amperex Intelligence Technology (Shanghai) Limited, Shanghai 201306 (CN)
(72) Inventor: MA, Guolong, Shanghai 200120 (CN); PENG, Long, Shanghai 200120 (CN); LI, Pengtao, Shanghai 200120 (CN)
(74) Representative: Gong, Jinping
(86) International application number: PCT/CN2022/123416
(87) International publication number: WO 2024/065736

(57) **Abstract**

Provided is a voltage detection device. The device comprises a rod, a contact member and a probe. The contact member is rotatably connected to an axial end of the rod and configured to abut against an electric motor shaft, and the probe is electrically connected to the contact member. By means of rotationally connecting to a rod a contact member abutting against an electric motor shaft, the contact member can be rotated relative to the rod, and when the contact member abuts against the electric motor shaft in a rotating state, the contact member can rotate relative to the rod under the influence of the electric motor shaft, so as to change sliding friction to rolling friction between the contact member and the electric motor shaft, which significantly reduces the coefficient of friction between the contact member and the electric motor shaft, and thus reduces the wear and tear on the contact member, so that the service life of the contact member is prolonged, and thus the service life of the voltage detection device is prolonged.

## Description

### TECHNICAL FIELD

The present application belongs to the technical field of voltage detection and particularly relates to a voltage detection device.

### BACKGROUND

When a motor device normally runs, its motor shaft is in a high-voltage rotating state and will generate a certain shaft voltage. To ensure the normal operation of the motor device, the safety of the motor device can be monitored by detecting its shaft voltage state, as the shaft voltage state can effectively reflect the insulation condition of the motor shaft against the ground.

In the technical field of voltage detection, a voltage detection device that is in long-term contact with a motor shaft in a high-voltage rotating state will easily wear seriously, which affects the service life of the voltage detection device.

### SUMMARY

Embodiments of the present application provide a voltage detection device, which can prolong the service life of voltage detection devices.

Embodiments of the present application provide a voltage detection device, which includes a rod, a contact member, and a probe. The contact member is rotatably connected to one end of the rod in an axial direction and is configured to abut against a motor shaft, and the probe is electrically connected to the contact member.

Based on the above structure, by allowing the contact member abutting against the motor shaft to be rotatably connected to the rod, the contact member can rotate relative to the rod. When the contact member abuts against the motor shaft in a rotating state, the contact member can rotate relative to the rod under the influence of the motor shaft, such that sliding friction between the contact member and the motor shaft is changed into rolling friction. This significantly reduces the friction coefficient between the contact member and the motor shaft and thereby reduces the abrasion of the contact member, and thus the service life of the contact member is prolonged and thereby the service life of the voltage detection device is prolonged.

In some optional embodiments of the present application, the rod has an accommodating cavity penetrating through the rod along the axial direction, and at least a part of the probe is accommodated in the accommodating cavity and is in contact with the contact member.

Based on the above structure, providing the accommodating cavity enables the full use of the structure of the rod to provide the space for the probe.

In some optional embodiments of the present application, the voltage detection device further includes a rotating shaft provided in the accommodating cavity, and the contact member is rotatably connected to the rod via the rotating shaft.

Based on the above structure, providing the rotating shaft can facilitate relative rotation between the contact member and the rod.

In some optional embodiments of the present application, a rotation direction of the rotating shaft is parallel to the axial direction.

Based on the above structure, by allowing the rotation direction of the rotating shaft to be parallel to the axial direction, the rotation direction of the contact member can be approximately parallel to that of the motor shaft, such that the contact member can rely on the force of the motor shaft to rotate. In some optional embodiments of the present application, in a plane perpendicular to the axial direction, the rod includes a conductive layer and an insulating layer; the accommodating cavity is provided in the conductive layer, the insulating layer is provided on the outside of the conductive layer in a surrounding manner, and the contact member is connected to the conductive layer.

Based on the above structure, by providing the conductive layer, the accommodating cavity can be in a conductive environment. In the case that the probe gets loose from the contact member, the probe is not completely connected to the contact member, affecting the transmission of electric signals and thereby the detection process. In this case, if the probe is in contact with the conductive layer, the conductive layer enables the electric connection to the contact member, thus completing the transmission of the electric signals and improving the stress resistance of the detection device.

In some optional embodiments of the present application, the contact member is a brush head structure composed of a plurality of conductive filaments.

Based on the above structure, by allowing the contact member to be a brush head structure, in one aspect, the probe can easily extend into the inside of the contact member to allow the probe to be fully connected to the contact member, and in another aspect, the contact area between the contact member and the motor shaft is enlarged to guarantee that the contact member is connected to the motor shaft.

In some optional embodiments of the present application, the contact member is a conductive carbon brush.

Based on the above structure, by allowing the contact member to be a conductive carbon brush, the wear resistance of the contact member can be effectively improved, and the contact member is allowed to have a certain flexibility, which facilitates the attachment of the contact member to the motor shaft.

In some optional embodiments of the present application, the probe includes a contact end and a connection end, the contact end extends into the inside of the contact member, and the connection end extends out from one end in the accommodating cavity away from the contact member.

Based on the above structure, by providing the contact end, the connection of the probe to the contact member can be facilitated, and by providing the connection end, the connection of the probe to an external device for processing electric signals can be facilitated.

In some optional embodiments of the present application, the probe further includes a connection wire, and the connection wire is connected to the connection end and is used for transmitting electric signals received by the contact end.

Based on the above structure, by providing the connection wire, the connection of the probe to an external device for processing electric signals can be facilitated.

In some optional embodiments of the present application, the voltage detection device further includes a seal used for sealing one end of the accommodating cavity away from the contact member, and the connection wire or the connection end is capable of extending out of the accommodating cavity from the seal.

Based on the above structure, by providing the seal, a relatively sealed state can be generated inside the accommodating cavity, which reduces the influence of the external environment on the inside of the accommodating cavity and improves the detection precision.

In some optional embodiments of the present application, the voltage detection device further includes a detection body, the connection wire is connected to the detection body, and the detection body is used for processing and/or displaying electric signals obtained by the contact member.

Based on the above structure, by providing the detection body, the electric signals obtained by detection can be effectively processed.

In some optional embodiments of the present application, the rod is further provided thereon with a seal ring, and the seal ring is provided on the outside of the insulating layer.

Based on the above structure, by providing the seal ring, the mounting position can be sealed when the voltage detection device is connected to the mounting position. If the voltage detection device is provided on the motor and the motor has an opening for the passing through of the rod, the seal ring is used at this opening.

Compared with the prior art, in the voltage detection device according to the embodiments of the present application, by allowing the contact member abutting against the motor shaft to be rotatably connected to the rod, the contact member can rotate relative to the rod. When the contact member abuts against the motor shaft in a rotating state, the contact member can rotate relative to the rod under the influence of the motor shaft, such that sliding friction between the contact member and the motor shaft is changed into rolling friction. This significantly reduces the friction coefficient between the contact member and the motor shaft and thereby reduces the abrasion of the contact member, and thus the service life of the contact member is prolonged and thereby the service life of the voltage detection device is prolonged.

### BRIEF DESCRIPTION OF THE DRAWINGS

Features, advantages, and technical effects of exemplary embodiments of the present application will be described below with reference to the drawings.
FIG. 1 is a schematic structural diagram of a voltage detection device provided according to some embodiments of the present application.
FIG. 2 is a schematic structural diagram of a motor and a voltage detection device provided according to some embodiments of the present application.
FIG. 3 is a schematic structural diagram of a rotating shaft and a contact member provided according to some embodiments of the present application.
FIG. 4 is a schematic structural diagram of a voltage detection device provided according to some other embodiments of the present application.
FIG. 5 is a schematic structural diagram of a rotating shaft and a contact member provided according to some other embodiments of the present application.
FIG. 6 is a schematic structural diagram of a voltage detection device provided according to still some embodiments of the present application.

In the drawings:
100. Motor; 10. Motor shaft; 101. Housing; 1. Rod; 11. Accommodating cavity; 12. Conductive layer; 13. Insulating layer; 2. Contact member; 3. Probe; 31. Contact end; 32. Connection end; 33. Connection wire; 4. Rotating shaft; 41. Inner ring; 42. Outer ring; 43. Ball; 5. Seal; 6. Detection body; 7. Seal ring.

The drawings are not necessarily to scale.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

In the description of the present application, it should be noted that, unless otherwise specified, "a plurality" means two or more; the orientations or positional relationships indicated by the terms "upper", "lower", "left", "right", "inner", "outer", and the like are merely for the convenience of describing the present application and simplifying the description, rather than indicating or implying that the apparatus or element referred to must have a specific orientation or be configured and operated in the specific orientation, and thus shall not be construed as limitations to the present application. Furthermore, the terms "first", "second", "third", and the like are used for descriptive purposes only and shall not be construed as indicating or implying relative importance. The "perpendicular" is not strictly perpendicular but is within the allowable range of error. The "parallel" is not strictly parallel but is within the allowable range of error.

Reference in the present application to "embodiment" means that a particular feature, structure, or characteristic described in connection with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the described embodiments of the present application can be combined with other embodiments.

The following description is given with the directional terms as illustrated in the drawings and is not intended to limit the specific structure of the present application. In the description of the present application, it should further be noted that unless otherwise explicitly specified or defined, the terms "mount", "connect", and "link" shall be construed broadly and may be, for example, fixed connection, detachable connection, or integral connection, or direct connection or indirect connection via an intermediate. For those of ordinary skills in the art, the specific meaning of the above terms in the present application may be interpreted according to the specific condition.

In the technical field of voltage detection, there are various detection environments, and some environments have a large influence on voltage detection, such as the voltage detection of a motor. The motor generates a certain shaft voltage during normal operation, and the insulation defect of the motor shaft against the ground can be found by measuring the shaft voltage, such that the safety risk at the motor shaft is reduced.

The inventors noted that in the related art, when a shaft voltage is tested, a voltage signal needs to be led out from the surface of a motor shaft rotating at a high speed. To allow the surface of the motor shaft to be connected to an external detection device, usually a contact member needs to be used and connected to the surface of the motor shaft. However, the contact member needs the motor shaft rotating at a high speed for a long time, leading to serious abrasion of the contact member and a short service life of the voltage detection device.

To relieve the problem that the service life of the voltage detection device is short, the inventors have done research and found that by adjusting the structure of the contact member, the contact member can be rotationally connected to the structure for fixing the contact member. When the contact member abuts against the motor shaft in a rotating state, the contact member can rotate relative to the rod under the influence of the motor shaft, such that sliding friction between the contact member and the motor shaft is changed into rolling friction. This significantly reduces the friction coefficient between the contact member and the motor shaft and thereby reduces the abrasion of the contact member, and thus the service life of the contact member is prolonged and thereby the service life of the voltage detection device is prolonged.

Based on the above, the inventors of the present application have conducted in-depth studies and have designed a voltage detection device.

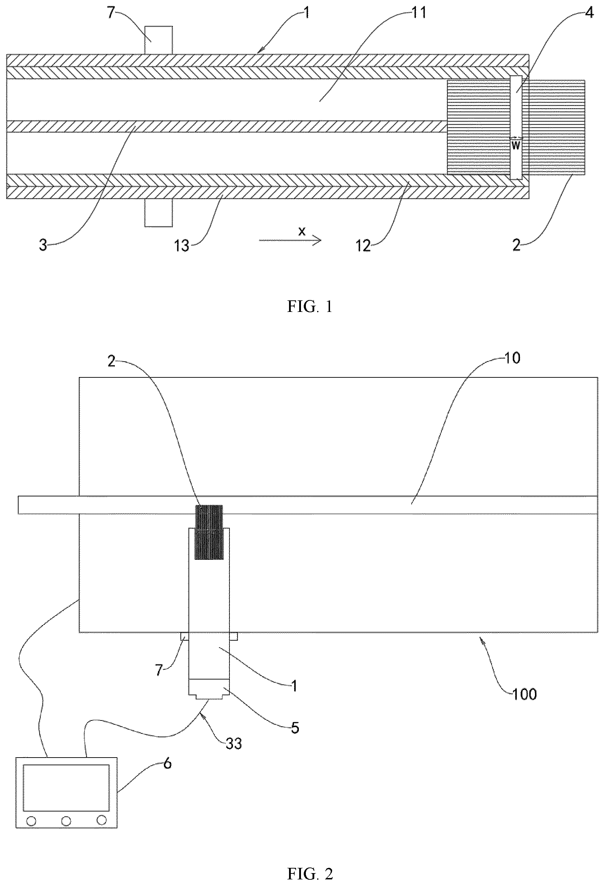

FIG. 1 is a schematic structural diagram of a voltage detection device provided according to some embodiments of the present application. As shown in FIG. 1, a voltage detection device is provided. The voltage detection device includes a rod 1, a contact member 2, and a probe 3. The contact member 2 is rotatably connected to one end of the rod 1 in the axial direction (x-axis direction in the figure), the contact member 2 is configured to abut against a motor shaft 10, and the probe 3 is electrically connected to the contact member 2.

The rod 1 is used for providing a supporting body for the voltage detection device, such that the voltage detection device is conveniently connected to a mounting position. Taking the mounting position being a motor 100 as an example, the rod 1 can be connected to a housing 101 of the motor 100.

The contact member 2 is configured to be in contact with the surface of the motor shaft 10 and lead out electric signals (such as voltage signals) thereon. Illustratively, the contact member 2 may be a contact rod, a brush, or the like, which is made of a conductive material.

The probe 3 is used for observing and receiving the electric signals led out from the contact member 2, and a differential probe 3 or the like may be used.

FIG. 2 is a schematic structural diagram of a motor 100 and a voltage detection device provided according to some embodiments of the present application. Referring to FIG. 2, taking the motor 100 as an example, the motor 100 includes a housing 101 and a motor shaft 10. The motor shaft 10 is partially provided inside the housing 101, the motor shaft 10 can rotate at a high speed relative to the housing 101, and the rod 1 is at least partially located inside the housing 101.

By allowing the contact member 2 abutting against the motor shaft 10 to be rotatably connected to the rod 1, the contact member 2 can rotate relative to the rod 1. When the contact member 2 abuts against the motor shaft 10 in a rotating state, the contact member 2 can rotate relative to the rod 1 under the influence of the motor shaft 10, such that sliding friction between the contact member 2 and the motor shaft 10 is changed into rolling friction. This significantly reduces the friction coefficient between the contact member 2 and the motor shaft 10 and thereby reduces the abrasion of the contact member 2, and thus the service life of the contact member 2 is prolonged and thereby the service life of the voltage detection device is prolonged.

Optionally, referring to FIG. 2, the rod 1 may extend from the outside of the housing 101 to the inside of the housing 101 and allow the contact member 2 to abut against the motor shaft 10.

Optionally, the contact member 2 and the rod 1 may be connected by a rotating structure (e.g., a rotating shaft 4).

Optionally, the rod 1 may be a hollow rod, and the probe 3 extends to one side of the contact member 2 through the hollow structure in the rod 1 and is connected to the contact member 2 to complete the electric connection between the probe 3 and the contact member 2.

Optionally, the rod 1 may be made of a conductive material. The contact member 2 is electrically connected to the rod 1, and the rod 1 is electrically connected to the probe 3, thus connecting the contact member 2 and the probe 3.

As shown in FIG. 1, in some optional embodiments of the present application, the rod 1 has an accommodating cavity 11. The accommodating cavity 11 penetrates through the rod 1 along an axial direction (x-axis direction in the figure) of the rod 1, the contact member 2 is rotatably connected to one end of the rod 1 along the axial direction, and at least a part of the probe 3 is accommodated in the accommodating cavity 11 and is in contact with the contact member 2. By providing the accommodating cavity 11, the structure of the rod 1 can be made full use of to provide space for the probe 3.

Optionally, the probe 3 may be a rod-like structure and extend axially within the accommodating cavity 11.

As shown in FIG. 1, in some optional embodiments of the present application, the voltage detection device further includes a rotating shaft 4, and the rotating shaft 4 is provided in the accommodating cavity 11 for allowing the contact member 2 to be rotatably connected to the rod 1. By providing the rotating shaft 4, the relative rotation between the contact member 2 and the rod 1 can be facilitated.

Optionally, the contact member 2 may have a wheel-like structure. The rotating shaft 4 is connected to the center of the contact member 2, and the contact member 2 can rotate around the center.

Optionally, the rotating shaft 4 is arranged in a direction parallel to the radial direction of the rod 1.

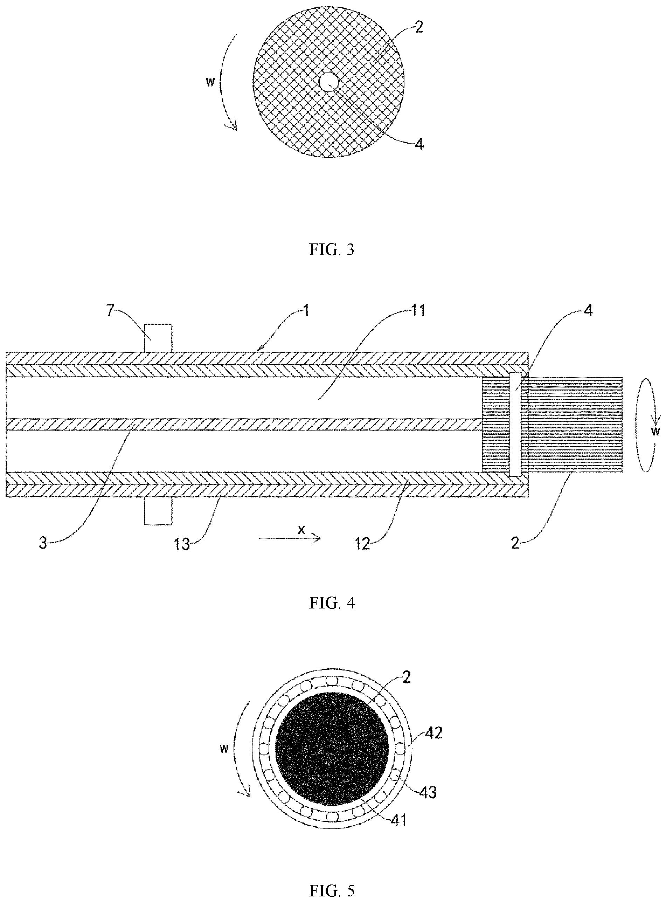

FIG. 3 is a schematic structural diagram of a rotating shaft 4 and a contact member 2 provided according to some embodiments of the present application. As shown in FIG. 1 to FIG. 3, in some optional embodiments of the present application, the rotation direction (w direction in the figures) of the rotating shaft 4 is parallel to the axial direction. By allowing the rotation direction of the rotating shaft 4 to be parallel to the axial direction, the rotation direction of the contact member 2 is approximately parallel to that of the motor shaft 10, such that the contact member 2 can rely on the force of the motor shaft 10 to rotate.

FIG. 4 is a schematic structural diagram of a voltage detection device provided according to some other embodiments of the present application, and FIG. 5 is a schematic structural diagram of a rotating shaft 4 and a contact member 2 provided according to some embodiments of the present application. Referring to FIG. 4 and FIG. 5, optionally, the rotation direction (w direction in the figure) of the rotating shaft 4 is perpendicular to the axial direction. By allowing the rotation direction of the rotating shaft 4 to be perpendicular to the axial direction, the contact member 2 can be basically in a fixed position when rotating, thereby reducing the space required by the rotation of the contact member 2 and reducing the influence of the rotation of the contact member 2 on other structures at the detection position.

Referring to FIG. 4 and FIG. 5, illustratively, when the rotation direction of the rotating shaft 4 is perpendicular to the axial direction, the rotating shaft 4 includes an inner ring 41, an outer ring 42, and balls 43. The balls 43 are provided between the inner ring 41 and the outer ring 42, the inner ring 41 can rotate relative to the outer ring 42, the inner ring 41 is connected to the contact member 2, and the outer ring 42 is connected to the side wall of the accommodating cavity 11. By providing the inner ring 41, the outer ring 42, and the balls 43, the rotatable connection between the contact member 2 and the rod 1 can be realized.

As shown in FIG. 1 and FIG. 4, in some optional embodiments of the present application, in a plane perpendicular to the axial direction, the rod 1 includes a conductive layer 12 and an insulating layer 13. The accommodating cavity 11 is provided in the conductive layer 12, the insulating layer 13 is provided on the outside of the conductive layer 12 in a surrounding manner, and the contact member 2 is connected to the conductive layer 12. By providing the conductive layer 12, the accommodating cavity 11 can be in a conductive environment. In the case that the probe 3 gets loose from the contact member 2, the probe 3 is not completely connected to the contact member 2, affecting the transmission of electric signals and thereby the detection process. In this case, if the probe 3 is in contact with the conductive layer 12, the conductive layer 12 enables the electric connection to the contact member 2, thus completing the transmission of the electric signals and improving the stress resistance of the detection device.

Optionally, the conductive layer 12 may be made of copper, such that the conductive layer 12 has excellent conductive characteristics.

As shown in FIG. 1 and FIG. 3, in some optional embodiments of the present application, the contact member 2 is a brush head structure composed of a plurality of conductive filaments. By allowing the contact member 2 to be a brush head structure, in one aspect, the probe 3 can easily extend into the inside of the contact member 2 to allow the probe 3 to be fully connected to the contact member 2, and in another aspect, the contact area between the contact member 2 and the motor shaft 10 is enlarged to guarantee that the contact member 2 is connected to the motor shaft 10.

Optionally, the contact member 2 may be a roller brush head structure.

In some optional embodiments of the present application, the contact member 2 is a conductive carbon brush. By allowing the contact member 2 to be a conductive carbon brush, the wear resistance of the contact member 2 can be effectively improved, and the contact member 2 is allowed to have a certain flexibility, which facilitates the attachment of the contact member 2 to the motor shaft 10.

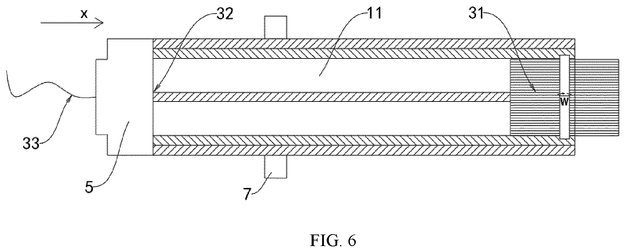

FIG. 6 is a schematic structural diagram of a voltage detection device provided according to still some embodiments of the present application. As shown in FIG. 6, in some optional embodiments of the present application, the probe 3 includes a contact end 31 and a connection end 32. The contact end 31 extends into the inside of the contact member 2, and the connection end 32 extends out from one end in the accommodating cavity 11 away from the contact member 2. By providing the contact end 31, the connection of the probe 3 to the contact member 2 can be facilitated, and by providing the connection end 32, the connection of the probe 3 to an external device for processing electric signals can be facilitated.

As shown in FIG. 2 and FIG. 6, in some optional embodiments of the present application, the probe 3 further includes a connection wire 33. The connection wire 33 is connected to the connection end 32, and the connection wire 33 is used for transmitting the electric signals received by the contact end 31. By providing the connection wire 33, the connection of the probe 3 to an external device for processing electric signals can be facilitated.

As shown in FIG. 2 and FIG. 6, in some optional embodiments of the present application, the voltage detection device further includes a seal 5. The seal 5 is used for sealing one end of the accommodating cavity 11 away from the contact member 2, and the connection wire 33 or the connection end 32 can extend out of the accommodating cavity 11 from the seal 5. By providing the seal 5, a relatively sealed state can be generated inside the accommodating cavity 11, which reduces the influence of the external environment on the inside of the accommodating cavity 11 and improves the detection precision.

Optionally, the seal 5 may be a plug-like structure for blocking one end of the accommodating cavity 11 away from the contact member 2. Illustratively, the seal 5 may be an insulating material, such as rubber and plastic.

As shown in FIG. 2 and FIG. 6, in some optional embodiments of the present application, the voltage detection device further includes a detection body 6. The connection wire 33 is connected to the detection body 6, and the detection body 6 is used for processing and/or displaying the electric signals obtained by the contact member 2. By providing the detection body 6, the electric signals obtained by detection can be effectively processed.

Optionally, the detection body 6 may be an oscilloscope.

Optionally, referring to FIG. 2, taking the detection of the voltage of the motor shaft 10 as an example, the positive electrode side of the probe 3 is connected to the contact member 2, and the negative electrode side of the probe 3 is connected to the housing 101.

As shown in FIG. 1 and FIG. 2, in some optional embodiments of the present application, the rod 1 is further provided thereon with a seal ring 7, and the seal ring 7 is provided on the outside of the insulating layer 13.

By providing the seal ring 7, the mounting position can be sealed when the voltage detection device is connected to the mounting position. If the voltage detection device is provided on the motor 100 and the motor 100 has an opening for the passing through of the rod 1, the seal ring 7 is used at this opening.

Optionally, the seal ring 7 is provided on the outside of the housing 101 and located at the joint of the housing 101 and the rod 1 for sealing the gap at the joint of the housing 101 and the rod 1. Illustratively, the seal ring 7 may be an oil seal ring.

In some optional embodiments of the present application, a voltage detection device is provided. The voltage detection device includes a rod 1, a contact member 2, and a probe 3. The contact member 2 is rotatably connected to the rod 1, and the contact member 2 is configured to abut against a motor shaft 10. The probe 3 is fixed to the rod 1 and is configured to be electrically connected to the contact member 2. The rod 1 has an accommodating cavity 11, and the accommodating cavity 11 penetrates through the rod 1 along an axial direction of the rod 1. The contact member 2 is rotatably connected to one end of the rod 1 along the axial direction, and at least a part of the probe 3 is accommodated in the accommodating cavity 11 and is in contact with the contact member 2. The voltage detection device further includes a rotating shaft 4. The rotating shaft 4 is provided in the accommodating cavity 11 for allowing the contact member 2 to be rotatably connected to the rod 1, and the rotation direction of the rotating shaft 4 is parallel to the axial direction. In a plane perpendicular to the axial direction, the rod 1 includes a conductive layer 12 and an insulating layer 13. The accommodating cavity 11 is provided in the conductive layer 12, the insulating layer 13 is provided on the outside of the conductive layer 12 in a surrounding manner, and the contact member 2 is connected to the conductive layer 12. The contact member 2 is a brush head structure composed of a plurality of conductive filaments. The probe 3 includes a contact end 31 and a connection end 32. The contact end 31 extends into the inside of the contact member 2, and the connection end 32 extends out from one end in the accommodating cavity 11 away from the contact member 2. The probe 3 further includes a connection wire 33. The connection wire 33 is connected to the connection end 32, and the connection wire 33 is used for transmitting the electric signals received by the contact end 31. The voltage detection device further includes a seal 5. The seal 5 is used for sealing one end of the accommodating cavity 11 away from the contact member 2, and the connection wire 33 or the connection end 32 can extend out of the accommodating cavity 11 from the seal 5. The voltage detection device further includes a detection body 6. The connection wire 33 is connected to the detection body 6, and the detection body 6 is used for processing and/or displaying the electric signals obtained by the contact member 2. The rod 1 is further provided thereon with a seal ring 7, and the seal ring 7 is provided on the outside of the insulating layer 13.

Although the present application has been described with reference to preferred embodiments, various modifications can be made and components can be replaced with equivalents without departing from the scope of the present application. In particular, the technical features mentioned in the embodiments may be combined in any manner as long as there are no structural conflicts. The present application is not limited to the specific embodiments disclosed herein, but encompasses all technical solutions falling within the scope of the claims.

## Claims

1. A voltage detection device, comprising:
a rod;
a contact member rotatably connected to one end of the rod in an axial direction and configured to abut against a motor shaft; and
a probe electrically connected to the contact member.

2. The voltage detection device according to claim 1, wherein the rod has an accommodating cavity penetrating through the rod along the axial direction, and at least a part of the probe is accommodated in the accommodating cavity and is in contact with the contact member.

3. The voltage detection device according to claim 2, wherein the voltage detection device further comprises a rotating shaft provided in the accommodating cavity, and the contact member is rotatably connected to the rod via the rotating shaft.

4. The voltage detection device according to claim 3, wherein a rotation direction of the rotating shaft is parallel to the axial direction.

5. The voltage detection device according to any one of claims 2 to 4, wherein in a plane perpendicular to the axial direction, the rod comprises a conductive layer and an insulating layer; the accommodating cavity is provided in the conductive layer, the insulating layer is provided on the outside of the conductive layer in a surrounding manner, and the contact member is connected to the conductive layer.

6. The voltage detection device according to any one of claims 1 to 5, wherein the contact member is a brush head structure composed of a plurality of conductive filaments.

7. The voltage detection device according to claim 6, wherein the contact member is a conductive carbon brush.

8. The voltage detection device according to any one of claims 1 to 7, wherein the probe comprises a contact end and a connection end, the contact end extends into the inside of the contact member, and the connection end extends out from one end in the accommodating cavity away from the contact member.

9. The voltage detection device according to claim 8, wherein the probe further comprises a connection wire, and the connection wire is connected to the connection end and is used for transmitting electric signals received by the contact end.

10. The voltage detection device according to claim 9, wherein the voltage detection device further comprises a seal used for sealing one end of the accommodating cavity away from the contact member, and the connection wire or the connection end is capable of extending out of the accommodating cavity from the seal.

11. The voltage detection device according to claim 10, wherein the voltage detection device further comprises a detection body, the connection wire is connected to the detection body, and the detection body is used for processing and/or displaying electric signals obtained by the contact member.

12. The voltage detection device according to claim 5, wherein the rod is further provided thereon with a seal ring, and the seal ring is provided on the outside of the insulating layer.
